# EUROPÄISCHE PATENTSCHRIFT

(11) **EP 2 460 021 B1**
(45) Veröffentlichungstag und Bekanntmachung des Hinweises auf die Patenterteilung: **26.03.2014**
(21) Anmeldenummer: 10720941.3
(22) Anmeldetag: 02.06.2010
(51) Int. Cl.: G01R 19/20, G01R 31/36, G01R 15/18

(54) **VERFAHREN UND VORRICHTUNG ZUR BESTIMMUNG EINES LADEZUSTANDS EINER BATTERIE MIT HILFE EINES FLUXGATE SENSORS**
METHOD AND DEVICE FOR DETERMINING A CHARGE STATUS OF A BATTERY USING A FLUXGATE SENSOR
PROCÉDÉ ET DISPOSITIF DE DÉTERMINATION DE L'ÉTAT DE CHARGE D'UNE BATTERIE, À L'AIDE D'UN CAPTEUR DE TYPE FLUXGATE

(30) Priorität: 31.07.2009 DE 102009028167
(43) Veröffentlichungstag der Anmeldung: 06.06.2012
(73) Patentinhaber: Robert Bosch GmbH, 70442 Stuttgart (DE)
(72) Erfinder: WENZLER, Axel, 78628 Rottweil (DE)
(86) Internationale Anmeldenummer: PCT/EP2010/057711
(87) Internationale Veröffentlichungsnummer: WO 2011/012361

(56) Entgegenhaltungen:
- EP-A1- 0 560 468
- DE-A1- 3 030 225
- DE-A1- 3 611 683
- DE-A1- 4 229 948
- DE-A1- 19 802 831
- DE-A1-102005 060 874
- DE-A1-102008 029 477
- DE-B1- 2 834 499
- SELINGER J F ET AL: "Robust reconstruction of nonuniformly sampled signals" CIRCUIT THEORY AND DESIGN, 2005. PROCEEDINGS OF THE 2005 EUROPEAN CONF ERENCE ON CORK, IRELAND 29TH AUGUST - 1ST SEPTEMB, PISCATAWAY, NJ, USA,IEEE LNKD- DOI:10.1109/ECCTD.2005.1522928, Bd. 1, 29. August 2005 (2005-08-29), Seiten 135-138, XP010845242 ISBN: 978-0-7803-9066-9

## Beschreibung

Die Erfindung betrifft eine Technik zur Bestimmung eines Ladezustands einer Batterie. Insbesondere betrifft die Erfindung ein Verfahren und eine Vorrichtung zur Bestimmung des Ladezustands einer Batterie in einem Kraftfahrzeug mittels eines Fluxgate-Magnetometers.

### Stand der Technik

Moderne Kraftfahrzeuge verfügen über eine Vielzahl von Subsystemen, die auf eine Versorgung mit elektrischem Strom angewiesen sind. Einige solcher Subsysteme, beispielsweise eine elektronische Wegfahrsperre oder eine Alarmanlage, können auch Strom verbrauchen, wenn ein Antriebsmotor des Kraftfahrzeugs nicht in Betrieb ist und der erforderliche Strom von einer Bordbatterie aufgebracht wird. Häufig treten die genannten Subsysteme nur in gewissen Intervallen in Aktion, und verbringen die restliche Zeit in einem stromsparenden Modus. Um nach einer längeren Standzeit des Kraftfahrzeugs einen Ladezustand der Batterie zu garantieren, der ausreicht, um den Antriebsmotor mittels eines elektrischen Startermotors in Gang zu setzen, werden die Subsysteme in Abhängigkeit eines Ladezustandes der Batterie gesteuert. Für die Bestimmung des Ladezustandes sind unterschiedliche Techniken bekannt. Üblicherweise erfordern diese, den Verlauf des Batteriestroms in die Batterie bzw. aus der Batterie zu bestimmen. Aus dem Stromverlauf kann auf eine Aufladung oder Entladung der Batterie geschlossen werden, aus der sich der Ladezustand der Batterie ermitteln lässt.

Zur Vermeidung einer galvanischen Kopplung bei einer Strombestimmung des Batteriestroms wird mittels eines Fluxgate-Magnetometers ein Magnetfeld bestimmt, das in einem mit der Batterie verbundenen Leiterstück durch den Batteriestrom induziert wird. Aus dem Magnetfeld wird dann der Batteriestrom bestimmt. Zur Magnetfeldmessung wird ein weichmagnetischer Spulenkern, der dem Magnetfeld des Leiterstücks ausgesetzt ist, mittels einer Sekundärspule zyklisch in die magnetische Sättigung getrieben. Während bestimmter Abschnitte eines solchen Messzyklus entspricht der durch die Spule fließende Strom dem durch das Übertragungsverhältnis geteilten Batteriestrom.

DE 42 28 948 A1 zeigt einen solchen Stromsensor auf der Basis eines Fluxgate-Magnetometers. Die Zeitabschnitte jedes Messzyklus, in denen der Spulenkern die magnetische Sättigung erreicht hat, können für eine Bestimmung des Magnetfeldes bzw. des Batteriestroms nicht verwendet werden, so dass das Fluxgate-Magnetometer in diesen Zeitabschnitten "blind" ist. Insbesondere bei elektrischen Verbrauchern mit periodisch veränderlicher Stromaufnahme können diese "blinden" Zeitabschnitte zu unzutreffenden Bestimmungen des Batteriestroms führen.

EP 0 560 468 A1 zeigt eine Vorrichtung zur Bestimmung eines Ladezustands einer Batterie auf der Basis eines Batteriestroms und anderer Parameter.

DE 42 29 948 A1 zeigt einen Stromsensor nach dem Fluxgate-Prinzip, der eine Mittelwertbildung von Messwerten unterstützt und eine Messpannungsquelle, eine Vergleichseinrichtung, eine Umpoleinrichtung, eine Abtasteinrichtung sowie eine Verarbeitungseinrichtung umfasst.

"Robust Reconstruction of Nununiformly Sampled Signals", Selinger J F et al, Circuit Theory and Design, 2005, Proceedings of the 2005 European Conference on Cork, Ireland, 29th August- 1st Septemb, Piscataway, NJ, USA, IEEE LNKD-DOI:10.1109/ECCTD.2005.1522928, Bd. 1, 29. August 2005 (2005-08-29), Seiten 135-138, ISBN 978-0-7803-9066-9, betrifft die Rekonstruktion nonuniform abgetasteter Signale.

DE 10 2005 060874 A1 betrifft ein Verfahren zur echtzeitfähigen Rekonstruktion eines nicht-äquidistant abgetasteten, analogen Signals.

### Offenbarung der Erfindung

Der Erfindung liegt daher die Aufgabe zugrunde, eine Technik anzugeben, eine Bestimmung eines Ladezustands einer Batterie in einem Kraftfahrzeug mittels eines Fluxgate-Magnetometers genauer und zuverlässiger zu machen. Die Aufgabe wird gelöst durch ein Verfahren nach Anspruch 1 und eine Vorrichtung nach Anspruch 6. Unteransprüche geben mögliche bzw. zweckmäßige Ausgestaltungen an.

Eine Spule, die mittels eines weichmagnetischen Spulenkerns mit einem vom Batteriestrom durchflossenen Leiterstück magnetisch gekoppelt ist, wird mit einer Messspannung beaufschlagt, bis ein durch die Spule fließender Sekundärstrom einen vorbestimmten Schwellenwert erreicht, was das Erreichen der magnetischen Sättigung des Spulenkerns anzeigt, woraufhin die Messspannung umgepolt wird. Erreicht der Sekundärstrom erneut den Schwellenwert, wird die Messspannung erneut umgepolt und ein Messzyklus ist vollständig durchlaufen. Während des Messzyklus wird der Sekundärstrom abgetastet und aus den Abtastungen wird der Verlauf des Sekundärstroms rekonstruiert. Der Ladezustand der Batterie wird anschließend auf der Basis des Verlaufs der Sekundärstromwerte bestimmt. Dabei wird das Rekonstruieren nur auf der Basis von Abtastungen durchgeführt, die außerhalb eines vorbestimmten zeitlichen Bereichs um die Zeitpunkte des Umpolens der Messspannung erhoben wurden.

Durch das Rekonstruieren des Verlaufs des Sekundärstroms werden auch Schwankungen im Batteriestrom erfassbar, die sich zu Zeitpunkten ereignen, zu denen eine unmittelbare Messung mittels des beschriebenen Aufbaus eines Fluxgate-Magnetometers nicht möglich ist. Insbesondere bei einer Bestimmung des Verlaufs des Batteriestroms über eine Vielzahl von Messzyklen hinweg wird mit dem angegebenen Verfahren eine Bestimmung von Stromschwankungen des Batteriestroms mit sogenannten Aliasfrequenzen (auch: Schwebungsfrequenzen) vermieden, die entstehen können, wenn ein periodisch schwankender Batteriestrom periodisch abgetastet wird und die beiden Perioden nicht übereinstimmen.

Der Sekundärstrom wird mehr als zweimal pro Zyklus abgetastet, beispielsweise in jedem Halbzyklus wenigstens zweimal oder öfter. Durch den Schritt des Rekonstruierens kann jede Einzelmessung die Genauigkeit der Bestimmung des Magnetfeldes verbessern, so dass praktisch keine Obergrenze für die Anzahl der Abtastungen pro Zyklus existiert. Für eine Steigerung der Anzahl Abtastungen pro Zeiteinheit kann somit eine Zykluszeit konstant bleiben, so dass auf eine Anpassung der Messanordnung verzichtet werden kann.

Die Abtastungen können mit unterschiedlichen Zeitabständen durchgeführt werden. Mit einer geeignet durchgeführten Rekonstruktion lassen sich derart nicht äquidistant abgetastete Werte verarbeiten, so dass Abtastungen vorzugsweise in den Bereichen des Zyklus erfolgen, in denen der Informationsgewinn durch die Abtastung maximiert ist. Dies ist beispielsweise in den Zeitabschnitten der Fall, in denen sich der weichmagnetische Spulenkern nicht in der magnetischen Sättigung befindet.

Das Rekonstruieren wird nur auf der Basis von Abtastungen durchgeführt, die außerhalb eines vorbestimmten zeitlichen Bereichs um die Zeitpunkte des Umpolens der Messspannung erhoben wurden. Das Umpolen der Messspannung erfolgt, wenn sich der weichmagnetische Spulenkern in der magnetischen Sättigung befindet. In einem gewissen zeitlichen Bereich um diesen Zeitpunkt liefert der Wert des Sekundärstroms keine verwertbare Information über das zu bestimmende Magnetfeld bzw. den das Magnetfeld hervorrufenden Batteriestrom. Abtastungen in diesem Bereich können daher mangels Informationsgewinn unterbleiben, oder in diesem Bereich vorgenommene Abtastungen können verworfen werden, so dass der Schritt des Rekonstruierens des Verlaufs des Sekundärstroms nur Abtastungen zur Basis hat, die auf den Batteriestrom hinweisen.

Mit der beschriebenen Technik lassen sich insbesondere periodische Batteriestromschwankungen erfassen, die durch Subsysteme des Kraftfahrzeugs hervorgerufen werden, die periodisch aktiviert sind.

Abtastzeitpunkte können auf der Basis einer zeitlichen Zyklusdauer eines vorangegangenen Zyklus bestimmt werden. In Abhängigkeit einer Reihe von Parametern, beispielsweise einem Betrag des Batteriestroms oder einer herrschenden Temperatur, kann ein Messzyklus unterschiedlich lange dauern, wobei zeitlich aufeinander folgende Messzyklen üblicherweise nur eine geringe Abweichung ihrer Zyklusdauern aufweisen. Die Länge eines Messzyklus liegt üblicherweise im Bereich von 2 bis 5 ms.

Der Ladezustand kann zusätzlich auf der Basis der Batteriespannung bestimmt werden, wobei die Batteriespannung zeitgleich mit dem Sekundärstrom abgetastet werden kann und der Verlauf der Batteriespannung auf der Basis der abgetasteten Batteriespannungswerte in entsprechender Weise bestimmt werden kann. Auf diese Weise kann garantiert werden, dass der rekonstruierte Verlauf der Batteriespannung und der rekonstruierte Verlauf des Batteriestroms miteinander synchronisiert sind, so dass aus unterschiedlich zeitlichen Bezügen keine Bestimmungsfehler resultieren. In einer alternativen Ausführungsform können abgetastete Batteriespannungswerte auch mittels eines Zeitgliedes zeitlich so verzögert werden, dass sie den entsprechenden Sekundärstromwerten nach der Rekonstruktion des Sekundärstromverlaufs zugeordnet werden können. Eine solche Verzögerung kann um eine statisch vorbestimmte Zeitdauer oder dynamisch um die jeweils zur vollständigen Rekonstruktion erforderliche Zeitdauer erfolgen.

Die genannte Technik kann in Form eines Anwender-spezifischen IC (ASIC) implementiert sein. Die Spule, der Spulenkern und die beschriebene Vorrichtung können in einer separaten Baugruppe integriert sein.

Die Abtastungen können mittels einer Ablaufsteuerung zeitlich gesteuert sein. Insbesondere können die Zeitpunkte von Abtastungen von der Ablaufsteuerung auf der Basis einer zeitlichen Zyklusdauer eines vorangegangenen Zyklus bestimmt werden.

Im Folgenden wird die Erfindung anhand der beiliegenden Figuren genauer erläutert, in denen
Figur 1 eine Messanordnung zum Bestimmen eines Batteriestroms nach dem Prinzip der magnetischen Kompensation;
Figur 2 einen zeitlichen Verlauf des Sekundärstroms im Fluxgate-Magnetometer aus Figur 1;
Figur 3 ein Ablaufdiagramm eines Verfahrens zur Bestimmung des Ladezustands der Batterie aus Figur 1, und
Figur 4 eine schematische Darstellung einer Vorrichtung zur Bestimmung des Ladezustands einer Batterie mit Hilfe des Fluxgate-Magnetometers aus Figur 1
darstellt.

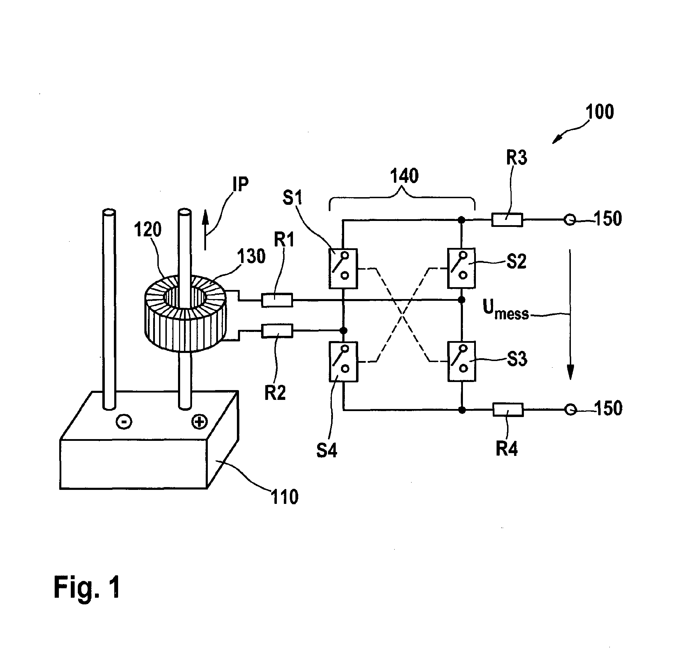

Figur 1 zeigt eine Messanordnung 100 zur Bestimmung eines Batteriestroms (Primärstroms) IP einer Batterie 110. Eine Spule 120 ist um einen torusförmigen Spulenkern 130, durch den ein Leiterstück zur Batterie 110 führt, gewickelt. Nicht dargestellte Verbraucher sind oberhalb der Darstellung mit der Batterie 110 verbunden. Zwei Anschlüsse der Spule 120 führen zu einer H-Schaltung 140. Diese umfasst die vier Schalter S1 bis S4, die derart miteinander synchronisiert sind, dass entweder nur S1 und S3 oder nur S2 und S4 geschlossen sind, so dass eine Messspannung Uₘₑₛₛ einer Messspannungsquelle 150 in normaler oder umgekehrter Polarität an die Spule 120 angelegt ist. An jedem der Messwiderstände (Shunts) R1 bis R4 fällt eine Spannung ab, die für den durch die Spule 120 fließenden Sekundärstrom IS charakteristisch ist. In der Praxis ist nur einer der Widerstände R1 bis R4 als Shunt ausgeführt, die anderen sind durch Leiterstücke ersetzt.

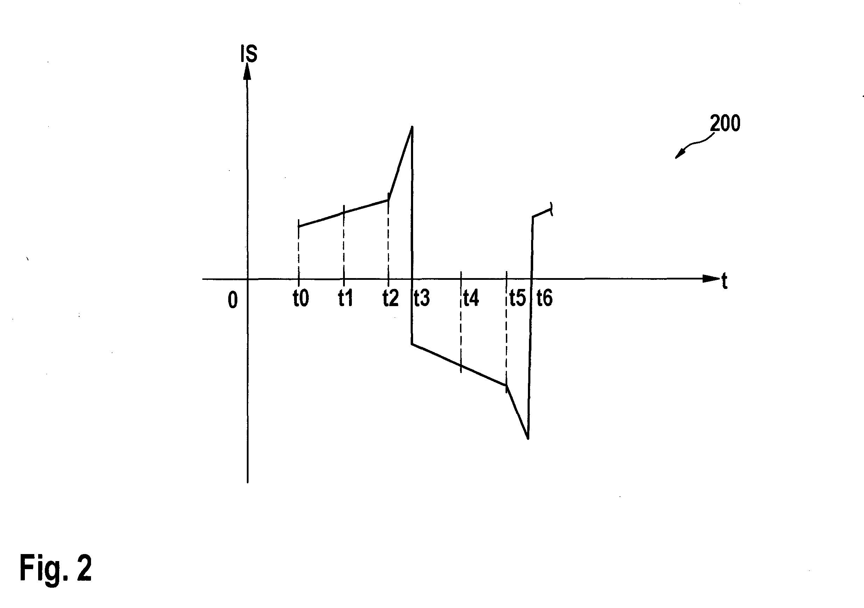

Das Prinzip einer Messung mittels der Messanordnung 100 wird nun anhand von Figur 2 erläutert, die einen zeitlichen Verlauf 200 des Sekundärstroms IS der Spule 120 aus Figur 1 illustriert. In Figur 2 ist in vertikaler Richtung der Sekundärstrom IS und in horizontaler Richtung eine Zeit t angetragen. Der dargestellte Verlauf 200 entspricht einem Messzyklus; nach diesem wiederholt sich der Ablauf.

Um den Spulenkern 130 ist ein Übertrager auf gebaut, dessen Primärwicklung aus dem mit der Batterie 110 verbundenen Leiterstück (Primärwicklungszahl: 1) und dessen Sekundärwicklung aus der Spule 120 (Sekundärwicklungszahl: üblicherweise 500 - 1000) besteht. Der Übertrager hat ein Übertragungsverhältnis entsprechend dem Verhältnis der Wicklungszahlen, also z.B. 1:500 bis 1:1000. Der Batteriestrom IP erzeugt in dem mit der Batterie 110 verbundenen Leiterstück ein Magnetfeld im Bereich des weichmagnetischen Spulenkerns 130. Der Sekundärstrom IS durch die Spule 120 soll nun so eingestellt werden, dass das mittels der Spule 120 hervorgerufene Magnetfeld das durch den Primärstrom erzeugte Magnetfeld genau kompensiert. Dann entspricht der Sekundärstrom IS, multipliziert mit dem Übertragungsverhältnis, dem Batteriestrom IP.

Nach Anlegen der Messspannung Uₘₑₛₛ an die Spule 120 zum Zeitpunkt t0 verhält sich die Spule 120 wie eine große Induktivität, während sie ein Magnetfeld aufbaut, und der durch sie fließende Sekundärstrom IS steigt langsam an. Zum Zeitpunkt t2 ist das aufgebaute Magnetfeld so groß, dass sich der Spulenkern 130 in der magnetischen Sättigung befindet, und die Spule 120 verhält sich wie eine kleine Induktivität, das heißt, der Sekundärstrom IS steigt schnell weiter. Zum Zeitpunkt t3, erreicht der Sekundärstrom IS eine vorbestimmte Schwelle, und die H-Schaltung 140 wird angesteuert, die an der Spule 120 anliegende Messspannung umzupolen.

Die Spule 120 verhält sich dann wieder wie eine kleine Induktivität, und der Sekundärstrom IS steigt mit geändertem Vorzeichen wieder langsam an, bis der Spulenkern 130 zum Zeitpunkt t5 in der entgegen gesetzten Richtung vollständig magnetisiert ist und in die magnetische Sättigung eintritt. Daraufhin verhält sich die Spule 120 wieder wie eine kleine Induktivität und der durch sie fließende Sekundärstrom IS steigt betragsmäßig schnell weiter. Zum Zeitpunkt t6 hat der Betrag des Sekundärstroms IS den Schwellenwert wieder erreicht und die H-Schaltung 140 wird angesteuert, die Messspannung Uₘₑₛₛ an der Spule 120 erneut umzupolen.

Derjenige Sekundärstrom IS, der zur gesuchten Kompensation von Magnetfeldern im Spulenkern 130 führt, ist jeweils in der Mitte derjenigen Bereiche des Verlaufs 200 des Sekundärstroms IS zu finden, in denen sich die Spule 120 wie eine große Induktivität verhält, also zu den Zeitpunkten t1 und t4. Ein betragsmäßiger Unterschied zwischen den Sekundärstromwerten IS zwischen den Zeitpunkten t1 und t4 ist durch eine Hysterese der um den Spulenkern 130 gewickelten Spule 120 bedingt. Der Mittelwert zwischen den beiden Sekundärstromwerten IS, multipliziert mit dem Übertragungsverhältnis, entspricht somit dem Batteriestrom IP.

Abtastungen des Sekundärstroms IS, die in den Zeitabschnitten t0 - t2 bzw. t3 - t5 stattfinden, können aufgrund der Linearität des Verlaufs 200 in diesen Bereichen dazu verwendet werden, die Bestimmung des Sekundärstroms IS zu den Zeitpunkten t1 und t4 zu verbessern. In den Zeitabschnitten t2 - t3 und t5 - t6, in denen sich der Spulenkörper 130 in der magnetischen Sättigung befindet, können keine für das zu bestimmende Magnetfeld aussagekräftige Abtastungen des Sekundärstroms IS durchgeführt werden.

Der Messzyklus von t0 bis t6 kann beispielsweise zu den folgenden Zeitpunkten zwölf Mal abgetastet werden:
[0,15; 0,20; 0,25; 0,30; 0,35; 0,40; 0,65; 0,70; 0,75; 0,80; 0,85; 0,90] * Tzyklus;
wobei Tzyklus die Zeitdauer zwischen t0 und t6 bezeichnet, die näherungsweise auf der Basis einer zeitlichen Zyklusdauer eines vorangegangenen Zyklus bestimmt werden kann. Die Zeitpunkte [0,05; 0,10; 0,45; 0,50; 0,55; 0,60; 0,95], die zu einer äquidistanten Abtastung des Verlaufs 200 fehlen, befinden sich in den Bereichen der magnetischen Sättigung t2 - t3 und t5 - t6, so dass auf eine Abtastung verzichtet wird.

Die auf diese Weise nicht äquidistant abgetasteten Werte des Sekundärstroms IS können im Rahmen einer anschließenden Verarbeitung zunächst so umgewandelt werden, dass sie gleiches Vorzeichen aufweisen, wie der Batteriestrom IP. Anschließend können die abgetasteten Werte um die Hysterese der um den Spulenkern 130 gewickelten Spule 120 und um die linearen Abweichungen im ersten Messabschnitt t0 - t2 und im zweiten Messabschnitt t3 - t5 kompensiert werden. Als Zwischenergebnis stehen dann eine Reihe nicht äquidistant abgetasteter Sekundärstromwerte IS bereit, die auf einem Batteriestrom IP zu unterschiedlichen Messzeitpunkten hinweisen. Um auch Änderungen des Batteriestroms IP zu erfassen, die in den Bereichen t2 - t3 und t5 - t6 liegen, werden die nunmehr vorliegenden Abtastwerte einer Signalrekonstruktion unterzogen, die periodische Signale zwischen den Abtastzeitpunkten rekonstruiert. Somit kann ein Verlauf des Sekundärstroms IS bereitgestellt werden, der dem tatsächlichen Batteriestrom IP auch über die "blinden" Abschnitte t2 - t3 und t5 - t6 sehr gut folgt. Aus diesem Verlauf kann mit hoher Zuverlässigkeit auf einen Ladezustand der Batterie 110 geschlossen werden.

Das Rekonstruieren kann periodische Anteile des Verlaufs des Sekundärstroms unterhalb einer vorbestimmten Maximalfrequenz abbilden. Beispielsweise kann das in der DE 10 2005 060 874 A1 offenbarte Verfahren zur echtzeitfähigen Rekonstruktion eines nicht-äquidistant abgetasteten analogen Signals für das Rekonstruieren verwendet werden. Bei diesem Verfahren werden eine Anzahl von Filtern bereitgestellt, die jeweils einen periodischen Teil des ursprünglichen Signals rekonstruieren. Die rekonstruierbare Maximalfrequenz des Signals richtet sich nach der Art bzw. Anzahl der Filter sowie der Anzahl der Abtastungen pro Messzyklus.

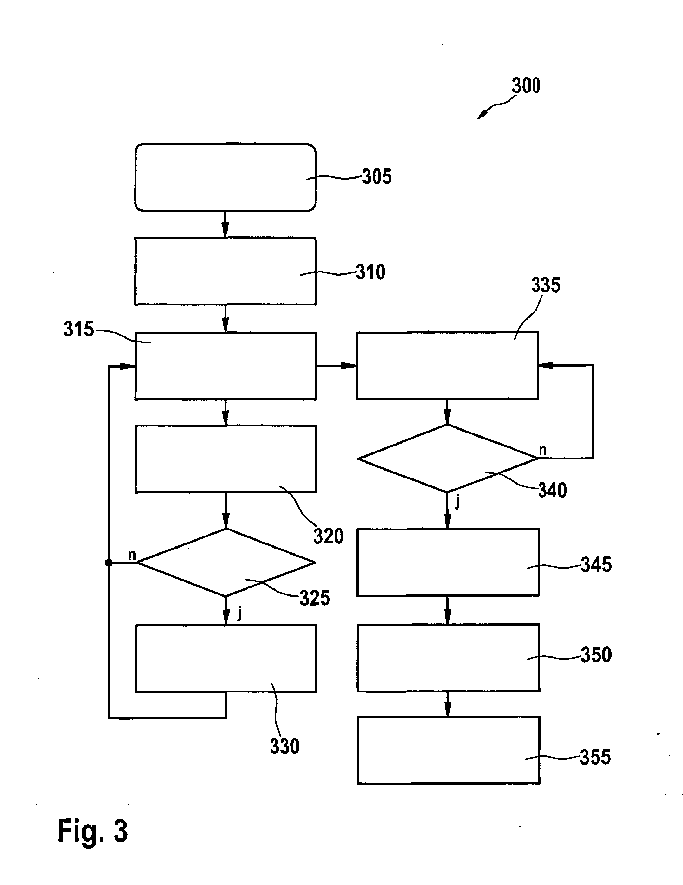

Figur 3 zeigt ein Verfahren 300 zum Bestimmen des Ladezustandes einer Batterie mit der Messanordnung 100 aus Figur 1. In einem Schritt 305 befindet sich das Verfahren im Startzustand. In einem Schritt 310 wird die Messspannung Uₘₑₛₛ an die Spule 120 angelegt. Nachfolgend werden in einem Schritt 315 der Sekundärstrom IS und die Batteriespannung der Batterie 110 abgetastet. Zeitpunkte für diese Abtastungen können auf der Basis einer Zyklusdauer eines vorangegangenen Messzyklus bestimmt werden, beispielsweise als vorbestimmte relative Zeitpunkte (5%, 10%,... der Zyklusdauer). Der abgetastete Sekundärstrom wird zweierlei ausgewertet. Einerseits wird der Sekundärstrom IS in einem Schritt 320 mit einem Schwellenwert verglichen und in einem Schritt 325 überprüft, ob der Sekundärstrom den Schwellenwert überschritten hat. Ist dies der Fall, so wird in einem Schritt 330 die Messspannung umgepolt. Aus den Schritten 325 oder 330 kehrt das Verfahren zum Schritt 315 zurück und durchläuft erneut.

Andererseits werden in einem Schritt 335 die im Schritt 315 abgetasteten Werte des Sekundärstroms IS gesammelt. In einem Schritt 340 wird sodann bestimmt, ob genügend Abtastwerte vorliegen. Dies ist üblicherweise der Fall, wenn Abtastwerte eines kompletten Messzyklus vorliegen. Ist dies nicht der Fall, kehrt das Verfahren zum Schritt 335 zurück und sammelt weitere Abtastwerte. Sind im Schritt 340 genügend Werte gesammelt, so werden in einem folgenden Schritt 345 die gesammelten Werte des Sekundärstroms IS vorverarbeitet, indem sie vorzeichengleich gemacht, um die Hysterese des Übertragers und bezüglich des linearen Verlaufs im Bereich t0 - t2 bzw. t3 - t5 kompensiert werden. Eine Vorverarbeitung der unmittelbar messbaren Batteriespannung kann entfallen. Anschließend werden in einem Schritt 350 Verläufe des Sekundärstroms IS und der Batteriespannung aus den abgetasteten Werten rekonstruiert. Schließlich wird in einem Schritt 355 auf der Basis der rekonstruierten Verläufe der Ladezustand der Batterie 110 bestimmt.

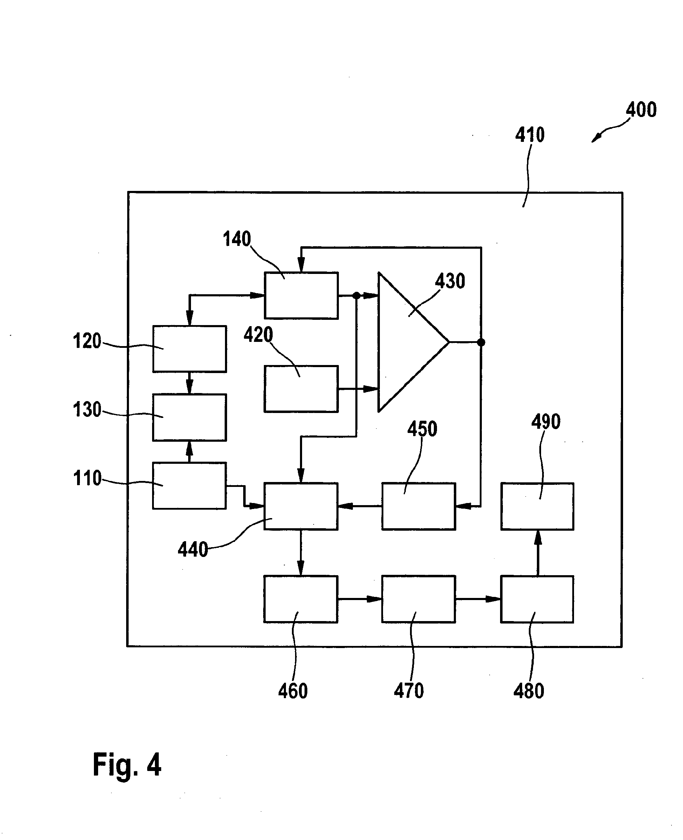

Figur 4 zeigt eine schematische Darstellung 400 einer Vorrichtung zur Bestimmung des Ladezustands einer Batterie mittels der Messanordnung 100 aus Figur 1. Die an Bord eines Kraftfahrzeugs 410 befindliche Vorrichtung umfasst die Batterie 110, die Spule 120, den Spulenkern 130 und die H-Schaltung 140 aus Figur 1. Die Elemente 110 bis 140 sind entsprechend der Messanordnung 100 in Figur 1 miteinander verbunden. Darüber hinaus umfasst die Vorrichtung einen Schwellenwertgeber 420, einen Komparator 430, einen Abtaster 440, eine Abtaststeuerung 450, eine Verarbeitungseinrichtung 460, einen Tiefpass 470, eine Bestimmungseinrichtung 480, sowie eine Energiesteuerung 490. Der Komparator 430 ist mit der H-Schaltung 140 und dem Schwellenwertgeber 420 verbunden und bestimmt, ob ein von der H-Schaltung 140 bereitgestellter Sekundärstrom IS den Schwellenwert überschreitet oder nicht. Ein entsprechendes Signal stellt er der Abtaststeuerung 450 und der H-Schaltung 140 zur Verfügung, woraufhin die H-Schaltung 140 die Messspannung Uₘₑₛₛ an der Spule 120 in Abhängigkeit des Signals umpolt. Der Abtaster 440 ist mit einem der Messwiderstände R1 bis R4 an der H-Schaltung 140 verbunden und erhält von diesem ein Signal, das auf den Sekundärstrom IS hinweist. Ferner ist der Abtaster 440 mit der Batterie 110 verbunden und bezieht von dieser ein Signal, das auf die Batteriespannung hinweist. Außerdem ist der Abtaster 440 mit der Abtaststeuerung 450 verbunden, um Abtastungen wie oben ausgeführt zu vorbestimmten Zeitpunkten durchzuführen.

Schließlich ist der Abtaster 440 auch mit der Verarbeitungseinrichtung 460 verbunden, und stellt dieser die Abtastwerte des Sekundärstroms IS und der Batteriespannung bereit. Die Verarbeitungseinrichtung 460 ist dazu eingerichtet, die oben mit Bezug auf Figuren 2 und 3 ausgeführte Verarbeitung der Abtastwerte, insbesondere die Rekonstruktion des Verlaufs des Sekundärstroms IS durchzuführen. Die Verarbeitungseinrichtung 460 ist mit dem Tiefpass 470 verbunden und stellt diesem die rekonstruierten Verläufe bereit. Der Tiefpass 470 ist mit der Bestimmungseinrichtung 480 verbunden und stellt dieser geglättete Verläufe bereit. Die Bestimmungseinrichtung 480 stellt über eine Verbindung mit der Energiesteuerung 490 einen von ihr bestimmten Ladezustand der Batterie 110 bereit. Die Energiesteuerung 490 ist dazu eingerichtet, einzelne Verbraucher an Bord des Kraftfahrzeugs 410 in Abhängigkeit des bestimmten Ladezustands der Batterie 110 in ihrem Energieverhalten zu beeinflussen, beispielsweise durch Verändern eines Aktivitäts- oder Ruheintervalls oder durch Deaktivieren.

## Patentansprüche

1. Verfahren (300) zum Bestimmen des Ladezustandes einer Batterie (110) in einem Kraftfahrzeug (410), folgende Schritte umfassend:
- Beaufschlagen einer Spule, die mittels eines weichmagnetischen Spulenkerns mit einem vom Batteriestrom durchflossenen Leiterstück magnetisch gekoppelt ist, mit einer Messspannung,
- zyklisches Umpolen (330) der Messspannung, wenn der Betrag des durch die Spule fließenden Sekundärstroms einen vorbestimmten Schwellenwert übersteigt;
- Abtasten (315) des Sekundärstroms mehr als 2-mal pro Zyklus;
- Rekonstruieren (350) des Verlaufs des Sekundärstroms auf der Basis der abgetasteten Sekundärstromwerte, und
- Bestimmen (355) des Ladezustandes auf der Basis des Verlaufs der Sekundärstromwerte; wobei
- das Rekonstruieren (350) nur auf der Basis von Abtastungen durchgeführt wird, die außerhalb eines vorbestimmten zeitlichen Bereichs um die Zeitpunkte des Umpolens der Messspannung erhoben wurden.

2. Verfahren (300) nach Anspruch 1, wobei die Abtastungen mit unterschiedlichen Zeitabständen ausgeführt werden.

3. Verfahren (300) nach einem der vorangehenden Ansprüche, wobei das Rekonstruieren (350) periodische Anteile des Verlaufs des Sekundärstroms unterhalb einer vorbestimmten Maximalfrequenz abbildet.

4. Verfahren (300) nach einem der vorangehenden Ansprüche, ferner umfassend den Schritt des Bestimmens (315) von Abtastzeitpunkten auf der Basis einer zeitlichen Zyklusdauer eines vorangegangenen Zyklus.

5. Verfahren (300) nach einem der vorangehenden Ansprüche, wobei der Ladezustand mit folgenden Schritten zusätzlich auf der Basis der Batteriespannung bestimmt wird:
- Abtasten (315) der Batteriespannung zeitgleich mit dem Sekundärstrom;
- Rekonstruieren (350) des Verlaufs der Batteriespannung auf der Basis der abgetasteten Batteriespannungswerte.

6. Vorrichtung (400) zur Bestimmung des Ladezustandes einer Batterie (110) in einem Kraftfahrzeug (410), umfassend:
- eine Messspannungsquelle (150) zum Beaufschlagen einer Spule (120), die mittels eines weichmagnetischen Spulenkerns mit einem vom Batteriestrom durchflossenen Leiterstück magnetisch gekoppelt ist, mit einer Messspannung;
- eine Vergleichseinrichtung (430) zum Vergleichen des Betrags des durch die Spule fließenden Sekundärstroms mit einem vorbestimmten Schwellenwert;
- eine Umpoleinrichtung (S1 - S4) zum zyklischen Umpolen der Messspannung in Abhängigkeit vom Vergleichsergebnis;
- eine Abtasteinrichtung (440) zum Abtasten des Sekundärstroms mehr als 2-mal pro Zyklus;
- eine Verarbeitungseinrichtung (460) zum Rekonstruieren des Verlaufs des Sekundärstroms auf der Basis der abgetasteten Sekundärstromwerte; und
- eine Bestimmungseinrichtung (480) zum Bestimmen des Ladezustandes auf der Basis des Verlaufs der Sekundärstromwerte; wobei
- die Verarbeitungseinrichtung (460) dazu eingerichtet ist, das Rekonstruieren nur auf der Basis von Abtastungen durchzuführen, die außerhalb eines vorbestimmten zeitlichen Bereichs um die Zeitpunkte des Umpolens der Messspannung erhoben wurden.

7. Vorrichtung (400) nach Anspruch 6, **gekennzeichnet durch** eine Abtaststeuerung (450) zur zeitlichen Steuerung der Abtastungen.

## Claims

1. Method (300) for determining the state of charge of a battery (110) in a motor vehicle (410), comprising the following steps:
- applying a measuring voltage to a coil which is magnetically coupled, by means of a soft-magnetic coil former, to a conductor element through which a battery current flows;
- cyclical polarity reversal (330) of the measuring voltage if the absolute value of the secondary current flowing through the coil exceeds a predetermined threshold value;
- sampling (315) of the secondary current more than 2 x per cycle;
- reconstruction (350) of the profile of the secondary current on the basis of the sampled secondary current values; and
- determining (355) the state of charge on the basis of the profile of the secondary current values; wherein
- the reconstruction (350) is carried out only on the basis of sampling operations which have been carried out outside a predetermined time range about the times of polarity reversal of the measuring voltage.

2. Method (300) according to Claim 1, wherein the sampling operations are carried out at different time intervals.

3. Method (300) according to one of the preceding claims, wherein the reconstruction (350) maps periodic portions of the profile of the secondary current below a predetermined maximum frequency.

4. Method (300) according to one of the preceding claims, but also comprising the step of determining (315) sampling times on the basis of a chronological cycle period of a preceding cycle.

5. Method (300) according to one of the preceding claims, wherein the state of charge is determined additionally on the basis of the battery voltage with the following steps:
- sampling (315) of the battery voltage simultaneously with the secondary current; and
- reconstruction (350) of the profile of the battery voltage on the basis of the sampled battery voltage values.

6. Device (400) for determining the state of charge of a battery (110) in a motor vehicle (410), comprising:
- a measuring voltage source (150) for applying a measuring voltage to a coil (120) which is magnetically coupled, by means of a soft-magnetic coil former, to a conductor element through which a battery voltage flows;
- a comparison device (430) for comparing the absolute value of the secondary current flowing through the coil with a predetermined threshold value;
- a polarity reversal device (S1-S4) for cyclically reversing the polarity of the measuring voltage as a function of the comparison result;
- a sampling device (440) for sampling the secondary current more than 2 x per cycle;
- a processing device (460) for reconstructing the profile of the secondary current on the basis of the sampled secondary current values; and
- a determining device (480) for determining the state of charge on the basis of the profile of the secondary current values; wherein
- the processing device (460) is configured to carry out the reconstruction only on the basis of sampling operations which have been carried out outside a predetermined time range about the times of polarity reversal of the measuring voltage.

7. Device (400) according to Claim 6, **characterized by** a sampling controller (450) for controlling the timing of the sampling operations.

## Revendications

1. Procédé (300) pour déterminer l'état de charge d'une batterie (110) dans un véhicule (410), comprenant les étapes suivantes :
- application d'une tension de mesure à une bobine qui est couplée magnétiquement par l'intermédiaire d'un noyau de bobine magnétique doux avec une pièce conductrice traversée par le courant de batterie ;
- inversion de polarité cyclique (330) de la tension de mesure lorsque la valeur absolue du courant secondaire qui circule à travers la bobine dépasse une valeur de seuil prédéfinie ;
- échantillonnage (315) du courant secondaire plus de 2 fois par cycle ;
- reconstruction (350) du tracé du courant secondaire en se basant sur les valeurs échantillonnées du courant secondaire ; et
- détermination (355) de l'état de charge en se basant sur le tracé des valeurs du courant secondaire ; procédé selon lequel
- la reconstruction (350) est seulement effectuée sur la base d'échantillonnages qui ont été relevés en dehors d'une plage de temps prédéfinie autour des instants d'inversion de polarité de la tension de mesure.

2. Procédé (300) selon la revendication 1, selon lequel les échantillonnages sont effectués avec des intervalles de temps différents.

3. Procédé (300) selon l'une des revendications précédentes, selon lequel la reconstruction (350) représente des parts périodiques du tracé du courant secondaire au-dessous d'une fréquence maximale prédéfinie.

4. Procédé (300) selon l'une des revendications précédentes, comprenant en plus l'étape de détermination (315) d'instants d'échantillonnage en se basant sur une durée de cycle temporelle d'un cycle précédent.

5. Procédé (300) selon l'une des revendications précédentes, selon lequel l'état de charge est déterminé avec les étapes suivantes en plus en se basant sur la tension de batterie :
- échantillonnage (315) de la tension de batterie simultanément avec le courant secondaire ;
- reconstruction (350) du tracé de la tension de batterie en se basant sur les valeurs échantillonnées de la tension de batterie.

6. Dispositif (400) pour déterminer l'état de charge d'une batterie (110) dans un véhicule (410), comprenant :
- une source de tension de mesure (150) pour appliquer une tension de mesure à une bobine (120) qui est couplée magnétiquement par l'intermédiaire d'un noyau de bobine magnétique doux avec une pièce conductrice traversée par le courant de batterie ;
- un dispositif comparateur (430) pour comparer la valeur absolue du courant secondaire qui circule à travers la bobine avec une valeur de seuil prédéfinie ;
- un dispositif d'inversion de polarité (S1-S4) pour inverser cycliquement la polarité de la tension de mesure en fonction du résultat de la comparaison ;
- un dispositif d'échantillonnage (440) pour échantillonner le courant secondaire plus de 2 fois par cycle ;
- un dispositif de traitement (460) pour reconstruire le tracé du courant secondaire en se basant sur les valeurs échantillonnées du courant secondaire ; et
- un dispositif de détermination (480) pour déterminer l'état de charge en se basant sur le tracé des valeurs du courant secondaire ; dispositif avec lequel
- le dispositif de traitement (460) est configuré pour effectuer la reconstruction seulement sur la base d'échantillonnages qui ont été relevés en dehors d'une plage de temps prédéfinie autour des instants d'inversion de polarité de la tension de mesure.

7. Dispositif (400) selon la revendication 6, **caractérisé par** une commande d'échantillonnage (450) pour la commande dans le temps des échantillonnages.
